# EUROPEAN PATENT APPLICATION

(11) **EP 3 104 335 A1**
(43) Date of publication of application: **14.12.2016**
(21) Application number: 16173846.3
(22) Date of filing: 10.06.2016
(51) Int. Cl.: G06T 17/20, G06T 19/20

(54) **ANALYSIS MODEL CREATION ASSISTANCE SYSTEM, ANALYSIS MODEL CREATION ASSISTANCE DEVICE AND ANALYSIS MODEL CREATION ASSISTANCE PROGRAM**

(30) Priority: 11.06.2015 JP 2015118405
(71) Applicant: Hitachi, Ltd., Tokyo 100-8280 (JP)
(72) Inventor: ONODERA, Makoto, Tokyo, Kanagawa 100-8280 (JP); HARIYA, Masayuki, Tokyo, Kanagawa 100-8280 (JP); HIRO, Yoshimitsu, Tokyo, Kanagawa 100-8280 (JP); KONGO, Chikara, Tokyo, Kanagawa 100-8280 (JP); SHINTANI, Masaki, Tokyo, Kanagawa 100-8280 (JP); UTSUNOMIYA, Tomoaki, Saitama, Kanagawa 351-0193 (JP); EGUCHI, Hisayuki, Saitama, Kanagawa 351-0193 (JP); TSUKAMOTO, Mamoru, Saitama, Kanagawa 351-0193 (JP)
(74) Representative: MERH-IP Matias Erny Reichl Hoffmann Patentanwälte PartG mbB

(57) **Abstract**

An analysis model creation assistance device comprises a mesh data registration unit (112) for registering a mesh data which has been already divided into meshes for a simulation in a mesh database (122), a CAD data registration unit (111) for registering a CAD data corresponding to the mesh data in a CAD database (121), and a usable mode extractor (113) for registering a mesh data corresponding to a data on mesh members excluding a mesh member of a largest size in a usable model database (123) as a usable mesh.

## Description

### TECHNICAL FIELD

The present invention relates to the techniques of an analysis model creation assistance system, an analysis model creation assistance device, and an analysis model creation assistance program in CAE (Computer Aided Engineering) for simulating physical phenomena numerically by numerical analysis using a computing machine.

### BACKGROUND ART

Numerical simulation mainly by a finite element method has been widely employed as means for understanding a phenomenon and solving a problem. It is necessary to generate an analysis model for performing simulation by a finite element method or the like. Analysis models have been enlarged and refined in accordance with sustainable improvement of computer processing capability and analysis technique, and further advancement is anticipated in the future. And, since a mesh quality of an analysis model greatly affects analysis accuracy, it has been important to establish mesh quality indicators and create meshes accordingly. Such situations have increased a burden on operation for analysis model creation, which is a problem to be overcome for efficiently utilizing simulation.

The techniques for creating a mesh automatically in an analysis model have been disclosed to overcome the foregoing problems.

Regarding such an automatic mesh generation technique in an analysis model, the following traditional techniques are known.

A first technique is described in a patent document 1. The technique described in the patent document 1 is a system to generate automatically rectangle meshes having sides constituting quadrilateral elements aligned along boundaries of an inputted graphics as close as possible.

A second technique is described in a patent document 2. The technique described in the patent document 2 is to input a mesh generation target shape and generate a plurality of kinds of bubbles in a shape field. Then, the technique described in the patent document 2 is to transfer the generated bubbles by the force between bubbles in accordance with the prescribed rules and adjust the number of bubbles so as to arrange the adjacent relation of the bubbles. As a result of the technique described in the patent document 2, stable arrangement of bubbles is determined. Finally, the technique described in the patent document 2 is to connect the centers of particular kind of bubbles out of a plurality of kinds of bubbles to generate meshes.

A third technique is described in a patent document 3. The technique described in the patent document 3 is to recognize geometric features of an existing analysis model by surface elements. Further, the technique described in the patent document 3 is to indicate dimension values (dimension restrictions) of deformed shapes to recognized geometric features or geometric features spaces, and to generate meshes by deforming meshes under constraints of such geometric features and dimension restrictions.

Furthermore, a fourth a technique is described in a patent document 4. The technique described in the patent document 4 is to divide CAD (Computer Aided Design) data for simulation into a plurality of parts of partial shapes and compare the shape similarities between respective partial shape parts and shapes of existing CAD data stored in a database. And, the technique described in the patent document 4 is to select an existing mesh data to be applied into partial shape parts and generate auto-mesh for partial shape parts not having similar CAD data in a database. Subsequently, the technique described in the patent document 4 is to generate mesh data for simulation by connecting meshes of respective partial shape parts.

### [Citation List]

### [Non Patent Literatures]

[Patent Document 1] Japanese Unexamined Patent Application Publication No.8-138082
[Patent Document 2] Japanese Unexamined Patent Application Publication No. 11-110586
[Patent Document 3] Japanese Unexamined Patent Application Publication No.2006-301753
[Patent Document 3] Japanese Unexamined Patent Application Publication No.2007-122205

### SUMMARY OF THE INVENTION

### Technical Problem

However, respective techniques as described above have the following problems.

Concerning the techniques described in the patent document 1 and the patent document 2, it may be difficult to secure a shape and qualities of a mesh (an interior angle and an edge length or the like). Meshes to be generated are not uniform, because some sections greatly affect analysis accuracy and other sections don't. Thus, meshes are generated mainly by designating parameters such as a mesh size and a quality for each section, which cannot satisfy a strong demand for reducing the number of steps or man-hours increases.

The technique described in the patent document 3 can cause a larger deformed mesh to deteriorate a mesh quality. Some methods or techniques for improving a mesh quality have already been proposed, however it is necessary to designate parameters such as a mesh size and a quality as indicators of quality improvement. Consequently, the problems similar to the ones found in the patent document 1 and the patent document 2 remain.

The technique described in the patent document 4 can cause data divided into a plurality of partial shape parts to increase more steps or man-hours. Also, the technique described in the patent document 4 doesn't specify the division method of partial shape parts, and it is assumed that partial shape parts divided by human operation. Therefore, in the technique described in the patent document 4, the result of similarity with a shape registered in a database can vary depending on division methods, which requires the know-how.

In consideration of such backgrounds, the present invention is made to generate element group possible to be used without an operation by a human.

### Solution to problem

In order to overcome the foregoing problems, the present invention comprises an acquirer for acquiring a mesh data divided into meshes for simulation, and a usable model extractor for dividing the above mesh data into data on a plurality of mesh members to designate a mesh data corresponding to a data on mesh members except a mesh member of a predetermined size as a usable mesh.

### Advantageous Effects of the Invention

The present invention enables generation of a usable mesh data without an operation by a human.

### BRIEF DESCRIPTION OF THE DRAWINGS

FIG.1 is a figure showing a configuration example of the analysis model creation assistance device according to the first embodiment.
FIG.2 is a figure showing a hardware configuration of the analysis model creation assistance device according to the first embodiment.
FIG.3A and Fig.3B are flowcharts showing the flow of the procedure in the analysis model creation assistance device according to the first embodiment.
FIG.4 is a figure showing an example of the operation screen in CAD data and mesh data registration processing.
FIG.5 is a flowchart (part1) showing the detailed procedure of usable model extraction processing according to the first embodiment.
FIG.6A and FIG.6B are figures showing examples of the mesh data which is what the usable model extraction processing deals with.
FIG.7A and FIG.7B are figures showing the T-connection edge extraction method.
FIG.8A and FIG.8B are figures showing the mesh states before and after separation.
FIG.9 is a figure showing the result of separation processing of mesh members.
FIG.10 is a figure showing examples of a plurality of usable meshes.
FIG.11 is a figure (part1) showing the mesh belonging face extraction method
FIG.12 is a figure (part2) showing the mesh belonging face extraction method.
FIG.13 is a figure (part1) showing an example of a CAD data.
FIG.14A and FIG.14B are figures showing examples of separated CAD members.
FIG.15 is a flowchart (part2) showing the detailed procedure of usable model extraction processing according to the first embodiment.
FIG.16 is a figure (part2) showing an example of CAD data.
FIG.17 is a figure showing the section of CAD data.
FIG.18 is a figure showing an example of a graph G0.
FIG.19 is a figure showing an example of a graph G1.
FIG.20 is a figure showing an example of a graph G2.
FIG.21 is a flowchart showing the detailed procedure of mesh generation processing according to the first embodiment.
FIG.22 is a figure showing the mesh deformation method.
FIG.23 is a figure showing examples of the mesh generation target CAD data and the mesh member of the non-similar part.
FIG.24A and FIG.24B are figures showing the mesh connection method.
FIG.25 is a figure showing a configuration example of an analysis model creation assistance system in the second embodiment.

### DESCRIPTION OF THE EMBODIMENTS

The embodiments to exploit the present invention will now be described in details with reference to the drawings appropriately.

### < Embodiment 1>

### [Device configuration]

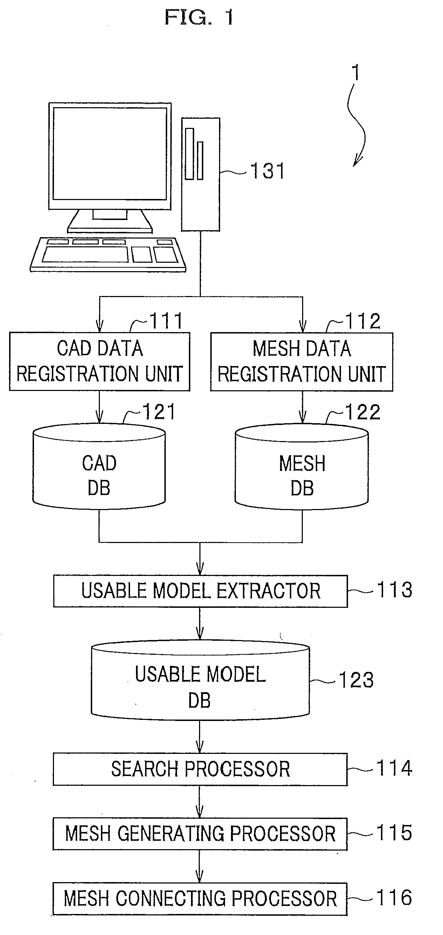

FIG.1 is a figure showing a configuration example of an analysis model creation assistance device according to a first embodiment.

An analysis model creation assistance device 1 comprises an input and output unit 131, a CAD data registration unit 111, a mesh data registration unit 112, a usable model extractor 113, a search processor 114, a mesh generating processor 115, and mesh connecting processor 116.

The input and output unit 131 mainly includes a keyboard and a pointing device with both of which a user inputs data, and a display for showing a data.

The CAD data registration unit 111 stores a CAD data created by a user in a CAD database 121.

The mesh data registration unit 112 stores the mesh data generated on the basis of a CAD data created by a user in a mesh database 122. Here, a mesh data refers to the mesh data used for a finite element method.

The usable model extractor 113 extracts usable partial shapes from a CAD data stored in the CAD database 121 and a mesh data stored in the mesh database 122 to store them as usable models in a usable model database 123.

The search processor 114 searches a CAD data (a mesh generation target CAD data) to be divided into meshes for parts (similar shapes) similar to each usable model stored in the usable model database 123.

The mesh generating processor 115 generates a mesh for a non-similar part in which no shapes similar to usable models have been found in a mesh generation target CAD data as a result of searching by the search processor 114.

The mesh connecting processor 116 arranges a mesh data of a usable model determined as similar shapes at a corresponding position in a mesh generation target CAD data, and connects a mesh data of a usable model to a mesh model of a non-similar part. Consequently, the mesh connecting processor 116 generates a mesh data corresponding to a mesh generation target CAD data.

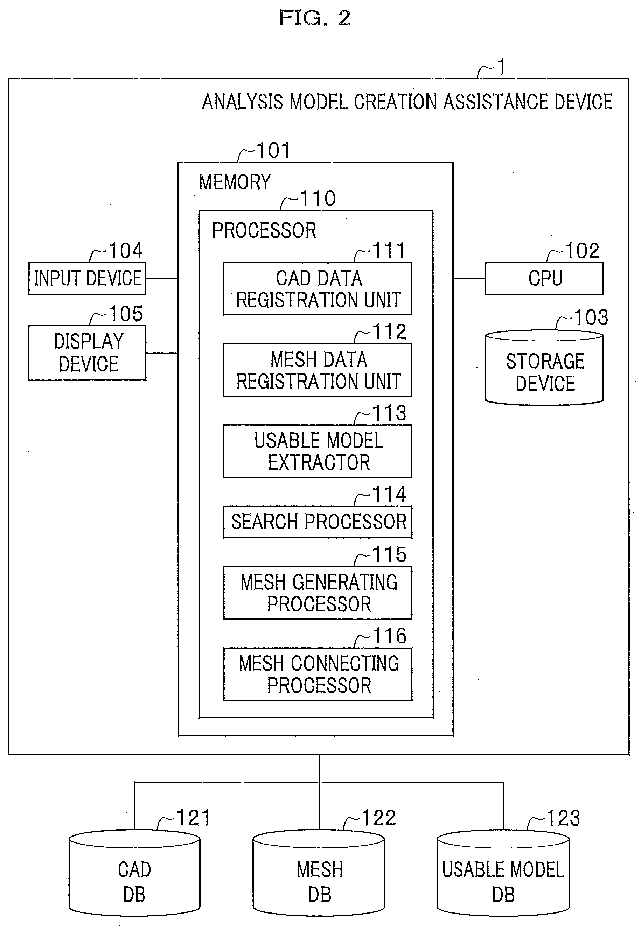

FIG.2 is a figure showing the hardware configuration of the analysis model creation assistance device according to a first embodiment.

An analysis model creation assistance device 1 comprises a storage 101, CPU (Central Processing Unit) 102, a storage device such as a HD (Hard Disk), a keyboard, an input device 104 such as a pointing device, a display device 105 such as a display. Here, the input device 104 and the display device 105 correspond to the input and output unit 131 in FIG.1.

And, the program stored in the storage device 103 is developed by the storage 101 and executed by the CPU 102 to embody a processor 110 and the CAD data registration unit 111 comprising the processor 110 and, the mesh data registration unit 112, the usable model extractor 113, the search processor 114, the mesh generating processor 115, and mesh connecting processor 116. As respective parts from 111 to 116 have already been described in FIG.1, a further description will be omitted here.

Also, the analysis model creation assistance device 1 is connected to the CAD database 121, the mesh database 122, and the usable model database 123.

Although in the present embodiment the CAD database 121, the mesh database 122, and the usable model database 123 are provided separately from the analysis model creation assistance device 1, at least one of them may be integrated with the analysis model creation assistance device 1.

Alternatively, at least one of respective parts from 111 to 116 may be provided not in the analysis model creation assistance device 1 but in another device.

### [Overall flowchart]

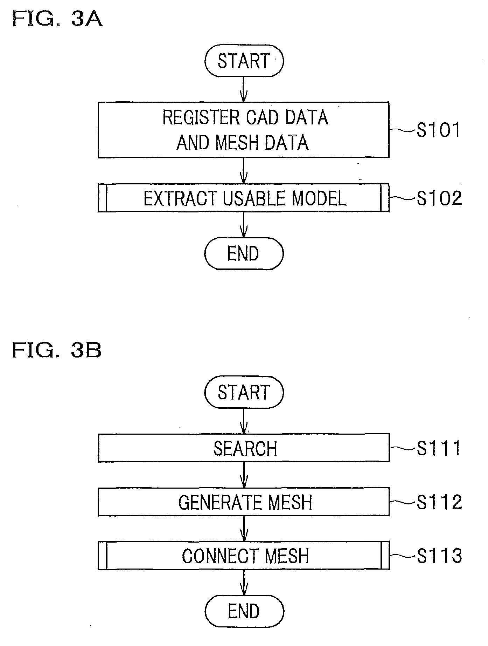

FIG.3A and FIG.3B are flowcharts showing the processing procedure in the analysis model creation assistance device according to the first embodiment.

The details of each processing in FIG.3A and FIG.3B will be described later.

FIG.3A is a flowchart showing the procedure of usable model generation processing.

First, CAD data and mesh data registration processing is performed in which the CAD data registration unit 111 and the mesh data registration unit 112 register a CAD data and a mesh data in the CAD database 121 and the mesh database 122 (S101).

Next, a usable model extraction processing is performed in which the usable model extractor 113 extracts usable models of a usable CAD and a usable mesh from a CAD data a mesh data respectively (S102).

FIG.3B is a flowchart showing the procedure of mesh generation processing. This processing is intended to apply usable models into a CAD data (a mesh generation target CAD data) to generate a mesh data.

First, the search processor 114 performs search processing for searching whether there are parts into which usable models can be used in a mesh generation target CAD data newly input or not (S111) .

Next, the mesh generating processor 115 performs mesh generation processing on the parts into which usable models cannot be used (S112).

Then, the mesh connecting processor 115 performs mesh connection processing for connecting a mesh data generated on the basis of a mesh data of a usable model to a mesh data of parts in which no usable models have been detected in Step 111 (S113).

### [Details of each processing]

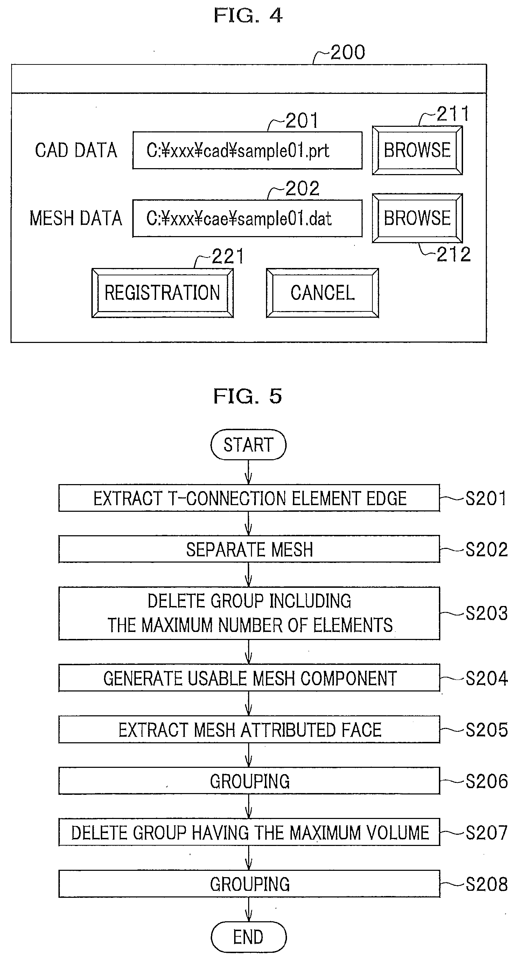

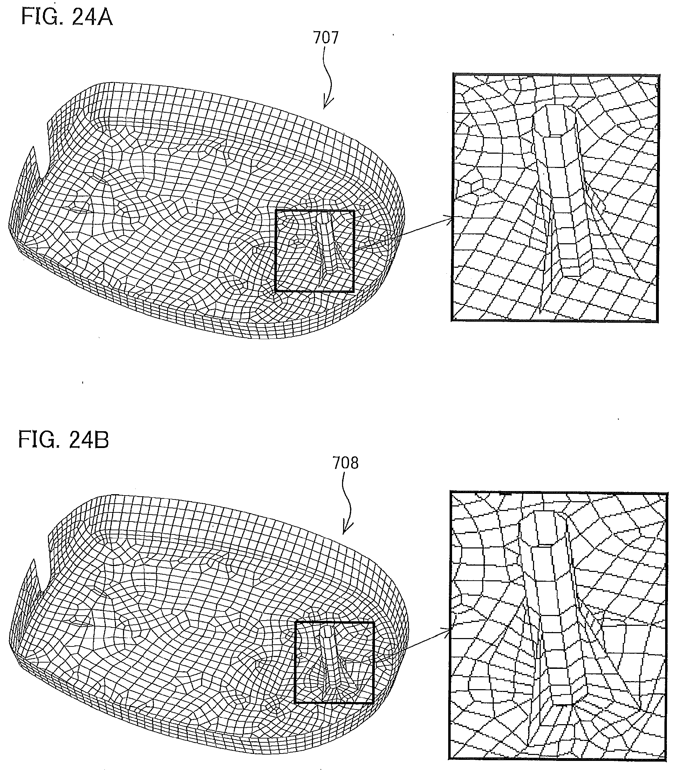

Next, with reference to FIG.4 to FIGS.24A and 24B, the details of each processing in FIG.3A and FIG.3B are indicated. Hereinafter, FIG.1 and FIG.2 are referred, if necessary.

### (CAD data and mesh data registration processing)

FIG.4 is a figure showing an example of the operation screen in a CAD data and a mesh data registration processing (S101 in FIG.3 A).

As shown in FIG.4, an operation screen 200 includes a CAD data designating window 201 and a mesh data designating window 202.

A user designates a CAD data and a mesh data by operating browse buttons 211 and 212 or the like.

Thereafter, a registration button 221 is selected and input through the input and output unit 131(FIG.1), and the designated CAD data and mesh data are stored in the CAD database 121 and the mesh database 122 as associated information. Here, "being stored as associated information" means to be tied mainly by a link and then stored.

In addition, a CAD data and a mesh data from which usable models are extracted need to be associated with each other. For this reason, a CAD data and a mesh data in which usable models are searched are preferably designated on the same operation screen as shown in FIG.4.

### (Usable model extraction processing)

Next, with reference to FIG.5 to FIG.20, usable model extraction processing (S102) in FIG.3A will be described in details.

### (Shell mesh)

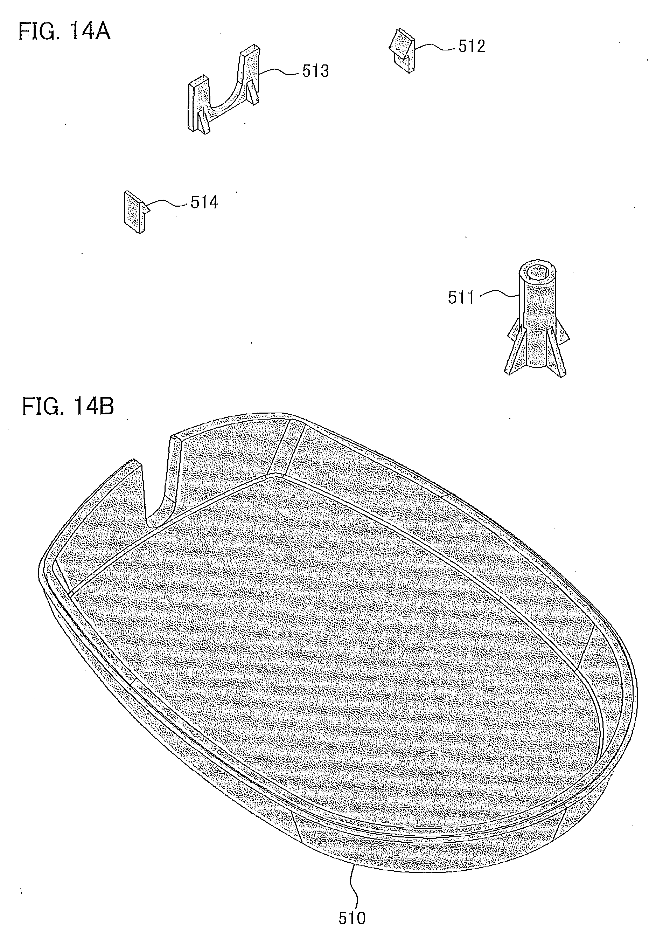

First, with reference to FIG.5 to FIG.14A and FIG.14B, usable model extraction processing in case of a shell mesh (two-dimensional mesh composed of rectangle meshes and triangle meshes) will be described.

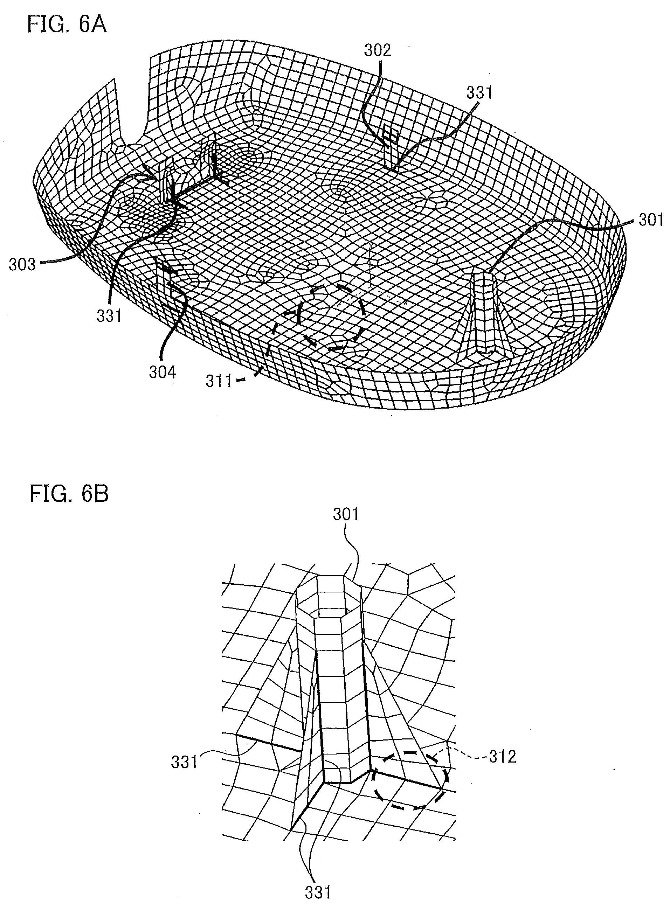

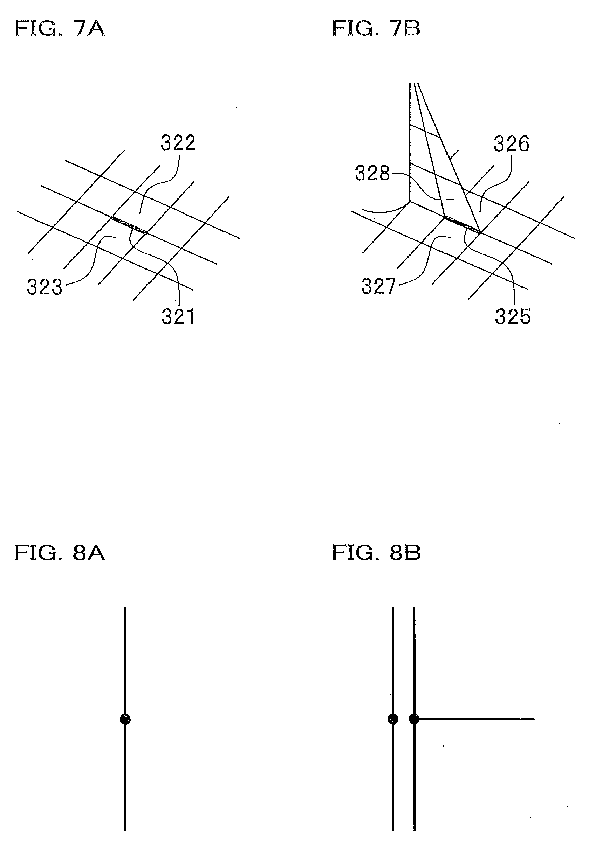

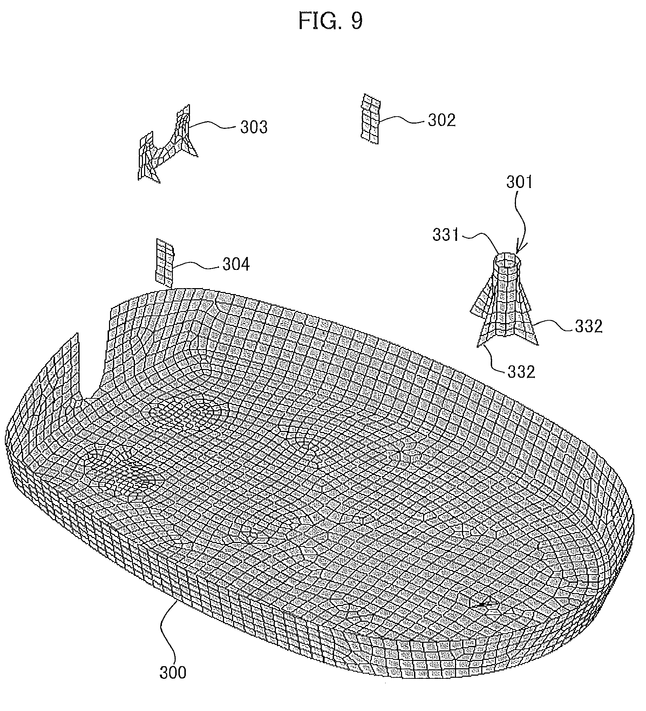

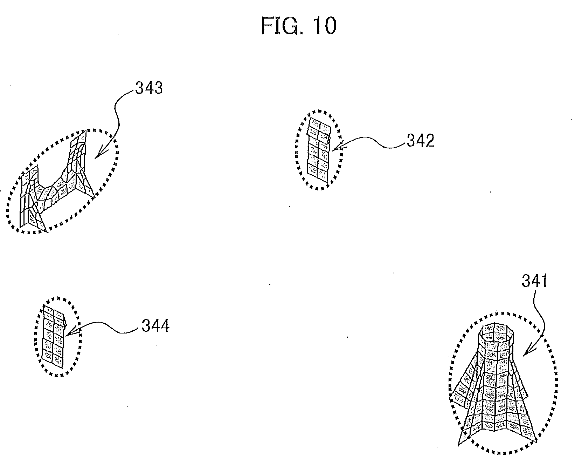

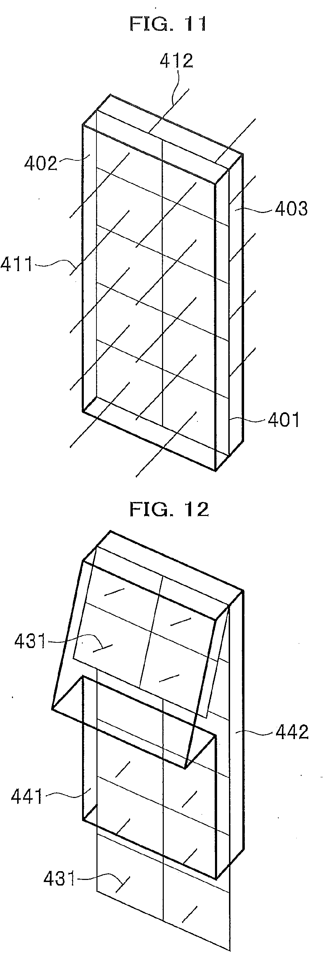

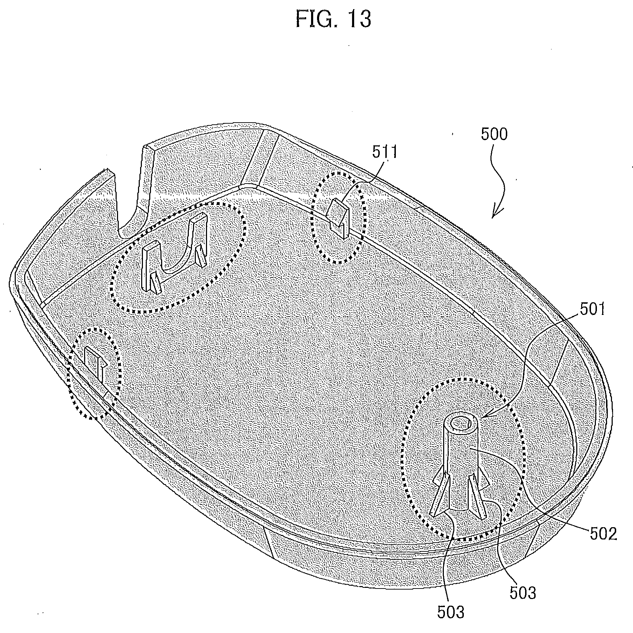

FIG.5 is a flowchart (part1) showing the detailed procedure of usable model extraction processing according to the first embodiment. FIG.6A and FIG.6B are figures showing an example of a mesh data which is what usable model extraction processing deals with. FIG.7A and FIG.7B are figures showing the T-connection edge extraction method FIG.8A and FIG.8B are figures showing the mesh states before and after separation. FIG.9 is a figure showing the result of separation processing of mesh members. FIG.10 is a figure showing examples of a plurality of usable mesh. FIG.11 is a figure (part1) showing the mesh belonging face extraction method. FIG.12 is a figure (part2) showing the mesh belonging face extraction method. FIG.13 is a figure (part1) showing an example of a CAD data. FIG.14A and FIG.14B are figures showing examples of separated CAD members.

Usable model extraction processing is intended to search associated CAD data and mesh data registered in the CAD database 121 and the mesh database 122 (see FIG.1 for both) for usable partial shapes and to register them as usable models in the usable model database 123. In addition, the processing as indicated in FIG.5 is an effective method for a shell mesh.

It is an object to extract the mesh members 301 to 304 from the mesh data as shown in FIG.6A and further extracts CAD members corresponding to the mesh members 301 to 304.

First, in Step 201 in FIG.5, the usable model extractor 113 extracts an element edge (referred to as T-connection element edge hereinafter) to which three or more elements belong in the sides (referred to as element edge hereinafter) constituting elements of a mesh data.

A Step 201 in FIG.5 will now be described in details. FIG.7A is an enlarged figure of the part of a symbol 311, and FIG.7B is an enlarged figure of the part of a symbol 312. In addition, FIG.6B is an enlarged figure of the vicinity of the mesh member 301 in FIG.6A.

As shown in FIG.7A, tow elements belong to one element edge on the same mesh member. For instance, two elements 322 and 323 belong to an element edge 321.

On the other hand, at a position in which different mesh members are in contact with each other, three or more elements belong to one element edge. For instance, three elements 326 to 328 belong to an element edge 325 as shown in FIG.7B.

Thereby, the usable model extractor 113 extracts element edges (T-connection element edges) to which three or more elements belong as the element edge 325 in FIG.7B.

As a result of Step 201, the T-connection element edges indicated by a symbol 331 or the like in FIG.6A and FIG.6B are extracted.

Next in Step 202 in FIG.5, the usable model extractor 113 separates mesh members by T-connection element edges.

With reference to FIG.8A and FIG.8B, the processing of Step 202 will now be described. Here, FIG.8A shows the mesh before separation, and FIG.8B shows the mesh after separation.

As shown in FIG.8A, before separation, a node and an element edge in a connection point are shared by three elements. As shown in FIG.8B, after separation, a node and an element in a connecting point are not shared by being in contact with each other.

FIG.9 gives the result of Step 202. For the sake of convenience in FIG.9, the mesh members 301 and 302 are seen completely separated from a mesh member 300, however, actually the mesh members 301 and 302 are separated in contact with the mesh member 300. In other words, the mesh members 301 and 302 have the element edges and nodes that they have being in contact with the element edges and nodes that the mesh member 300 has. And, the mesh member 301 is separated from a cylindrical mesh member 331 (a first mesh member) and an approximately triangular mesh member 332 (the first mesh member). The same is applied to the mesh member 303.

In Step 203 in FIG.5, the usable model extractor 113 moves each separated mesh member constituted by a set of elements and deletes the group including the maximum number of elements.

Namely, the usable model extractor 113 deletes the mesh member 300 including the maximum number of elements (the largest first mesh member) in FIG.9. In addition, succeeding processing may be performed not by deleting the mesh member 300 including the maximum number of elements but by removing it temporarily. Also, the mesh member 300 including the determined number of elements may be deleted. This can prevent the mesh member 300 from being included in the grouping of Step 204.

FIG.10 shows the result of the processing by Step 203 in FIG.5.

Next in Step 204 in FIG.4, the usable model extractor 113 returns the mesh member separated from T-connection element edges to the original and moves again each mesh member constituted by a set of elements to generate a mesh data for a usable model in each mesh member (a mesh member grouped in Step 204 is referred to as a usable mesh).

Namely, the usable model extractor 113 performs grouping the mesh members both of which elements are mutually contacted out of mesh members 301 to 304 in FIG. 9 to extract four usable mesh members 341 to 344 (second mesh members) in FIG.10. In other words, as described in FIG.9, the mesh member indicated by a symbol 301 is actually separated from the mesh member 331 and the mesh member 332. In Step 204 in FIG.5, the usable model extractor 113 connects the mesh member 331 and the mesh member 332 (the first mesh members) both of which elements are mutually contacted and groups them to generate the usable mesh member 341 (the second mesh member). The same is applied to usable mesh members 342 to 344.

Thereby, a usable mesh can be extracted in a shell mesh without an operation by a human.

Subsequently, the usable model extractor 113 arranges an extracted usable mesh member on CAD data. This processing is executed on the basis of coordinates of a usable mesh and ones of a CAD data. And, in Step 205 in FIG.5, the usable extractor 113 draws normal lines (practically tangential planes) from at least one of internal points of each element in a usable mesh and extracts configuration faces of a CAD data intersecting with normal lines (referred to as mesh belonging faces hereinafter). Here, the length of normal lines is a thickness value of an element. This thickness may be either an average value of a whole CAD or a value of a CAD data on which a usable mesh is arranged.

With reference to FIG.11 and FIG.12, the processing of Step 205 will be described in details.

FIG.11 is a schematic diagram concerning the mesh belonging face extraction method in Step 205.

In FIG.11, a symbol 401 indicates a usable mesh and a symbol 402 and a symbol 403 indicates configuration faces of a CAD data.

And, symbols 411 and 412 indicate normal lines drawn from the usable mesh 401. As shown in FIG.11, the configuration faces 402 and 403 intersecting with the normal lines 411 and 412 of CAD data are mesh belonging faces for the usable mesh 401.
This processing can extract configuration faces, namely, a mesh belonging faces of a CAD data corresponding to a usable mesh member.

In this case, if the length of normal lines is infinite, they may intersect with configuration faces of other CAD data, however, by designating the length of normal lines as a thickness, normal lines intersect only with configuration faces of one CAD data.

Alternatively, CAD data configuration faces intersected by normal lines firstly are only determined as mesh belonging faces, while having the length of normal lines remained infinite.

FIG.12 is a figure showing the mesh belonging face corresponding to the usable mesh member 342 in FIG.10.

FIG.12 shows an example showing the usable mesh 344 of FIG.10 is arranged in the CAD member 511 of FIG.13. The normal lines 431 are drawn in the same method as the one used when normal lines 411 and 412 of FIG.11 are drawn, and the lengths of the normal lines 411 and 412 are the length of the normal line 431. In addition, the reason that the usable mesh 344 is protruded from the CAD member 511 in FIG.13 is that the usable mesh 344 is longer than the CAD member 511 by the thickness of the CAD member 514 in FIG. 14. In addition, some parts of the normal lines 431 are omitted in FIG.12.

The usable mode extractor 113 separates the mesh belonging face from the CAD data. Subsequently, the usable model extractor 113 performs grouping the obtained mesh belonging faces and the configuration faces connecting the mesh belonging faces (referred to as configuration faces relating to mesh belonging faces) to generate the CAD data (referred to as a usable CAD) corresponding to the usable mesh member from a CAD data. In this case, for instance, in an example of FIG.12, the configuration faces of the CAD member 514 in FIG.14A also are connected to the configuration faces of the CAD member 511, however, the CAD member 514 spreads outside the CAD member 511, thus doesn't connect the configuration faces 441 and 442 of the CAD member 511. Therefore, the configuration face of the CAD member 514 is not the configuration faces connecting the configuration faces 441 and 442.

In this step, for instance in the CAD member 501 in FIG.13, the respective mesh belonging faces of a cylindrical CAD member 501 and an approximately triangular CAD member 503 are connected with each other, however, the cylindrical CAD member 502 and the approximately triangular CAD member 503 are not connected with each other, because they are recognized as different CAD members.

Next, in Step 207 in FIG.5, the usable model extractor 113 deletes a CAD data of a maximum volume. In the present example, the group of maximum volume is a CAD member 510 in FIG.14B. Hence, what are left in the CAD data 500 of FIG.13 after deleting the CAD member 510 are shown in FIG.14A. In addition, the succeeding processing may be executed not by deleting a CAD data of a maximum volume but by removing it temporarily. Moreover, a CAD data of a predetermined volume may be deleted.

In Step 208 in FIG.5, grouping is performed again by connecting CAD members mutually contacted. For example, in Step 206 in FIG.5 as described above, in the CAD member 501 in FIG.13, the cylindrical CAD member 502 and the approximately triangular CAD member 503 are recognized as different CAD members not to be connected. Therefore, the usable mode extractor 113 performs grouping so as to connect the cylindrical member 502 and the approximately triangular CAD member 503 both of which mesh belonging faces contact with each other. Consequently, the CAD member 501 is recognized as one CAD member. The same is applied to the CAD members 502 to 504.

Symbols 511 to 514 in FIG.14A indicate the results of grouping.

And, the usable mode extractor 113 designates each group generated as a result of grouping in Step 207 as a usable CAD for a usable model. Thereafter, the usable model extractor 113 registers a usable CAD and a usable mesh to which a usable CAD belongs as associated usable models in the usable model database 123. For example, the usable mesh 341 in FIG.10 and the usable CAD 511 in FIG.14A are registered as associated usable models in the usable model database 123. Likewise, the usable mesh 342 in FIG.10 and the usable CAD 512 in FIG.14A are registered as associated usable models in the usable model database 123 in FIG.10. Also, the usable mesh 343 in FIG.10 and the usable CAD 513 in FIG.14A are registered as associated usable models in the usable model database 123. And, the usable mesh 344 in FIG.10 and the usable CAD 514 in FIG.14A are registered as associated usable models in the usable model database 123.

This processing can extract a usable CAD in a shell mesh without an operation by a human.

### (Solid mesh)

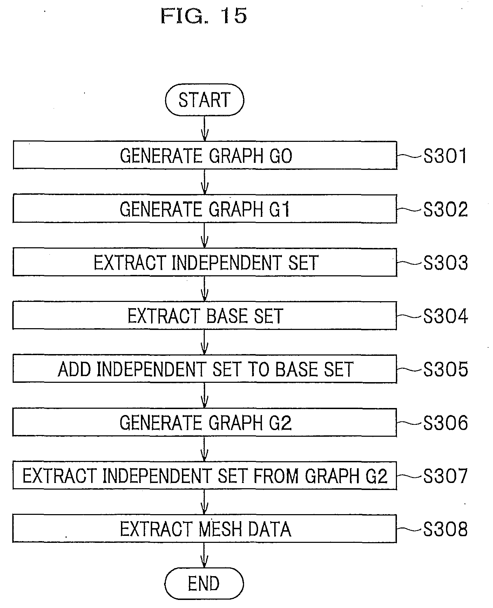

With reference to FIG.15 to FIG.20, the usable model extraction processing in case of a solid mesh will now be described in details.

Further, the processing illustrated in FIG.15 to FIG.20 can be applied into a shell mesh as well as a solid mesh (a mesh composed of hexahedrons, pentahedrons, and tetrahedrons).

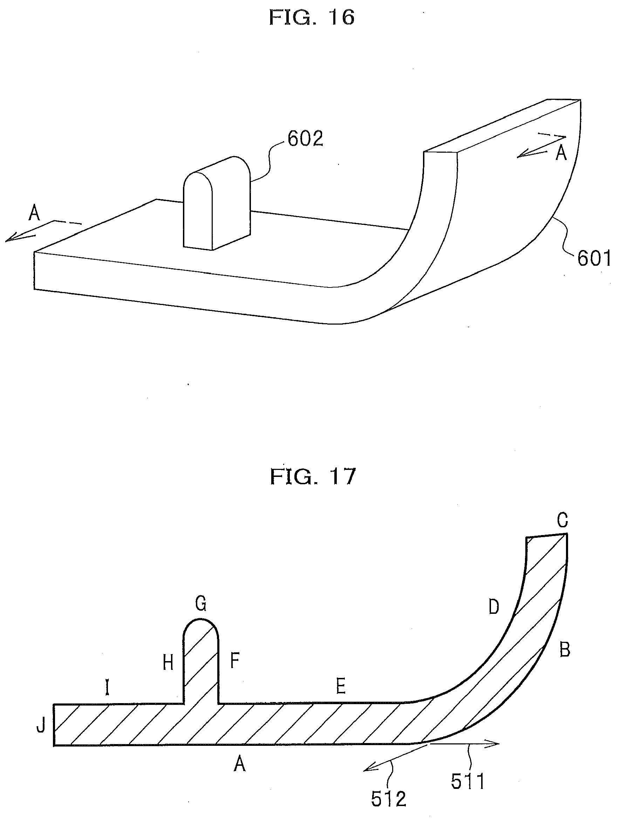

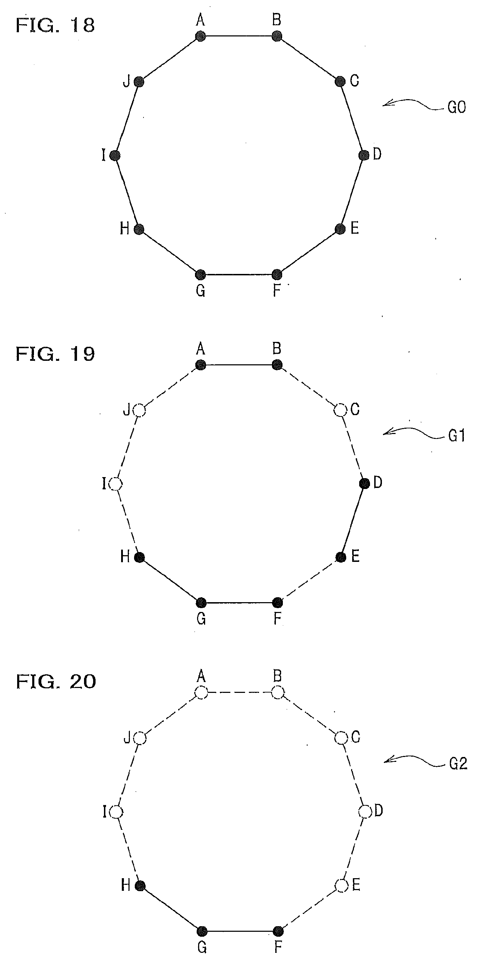

FIG.15 is a flowchart (part 2) indicating the detailed procedure of the usable model extraction processing according to the first embodiment. FIG.16 is a figure showing an example of a CAD data (part 2). FIG.17 is a figure showing a section of a CAD data. FIG.18 is a figure showing an example of a graph G0. FIG.19 is a figure showing an example of a graph G1. FIG.20 is a figure showing an example of a graph G2. The graphs G0 to G2 will be described later.

Here, it is an object to extract a CAD member 602 and a solid mesh corresponding to the CAD member 602 from a CAD data 601 in FIG.16. In this connection, the CAD data 601 in FIG.16 has a corresponding mesh data.

First, in Step 304 in FIG.15, the usable mode extractor 113 generates the graph G0 in which nodes represent the configuration faces of a CAD data and edges represent the phase relations between configuration faces of a CAD data.

FIG.17 which is a section taken along A-A of FIG.16 will be used to be easily described.

As illustrated in FIG.17, the CAD data comprises configuration faces A to J. The graph G0 (a first graph) in FIG.18 shows the connection relations of respective configuration faces A to J as a graph, while representing these configuration faces A to J as nodes.

Next, the usable model extractor 113 will search the graph G0 for edges in which an angle between mutual tangents in a connecting part of configuration faces is threshold or smaller (for instance 165 degrees). And, in Step 302 of FIG.15, the usable model extractor 113 generates the graph G1 (a second graph) which is left after the edges are deleted.

As an example, in FIG.17, an angle formed by a tangent 511 of a configuration face A and a tangent 512 of a configuration face B is 165 degrees or larger. The same is applied to angles formed by configuration surfaces D and E, configuration surfaces F and G, and configuration surfaces G and H. Thus, in describing "between nodes A and B "as "A,B ", the usable model extractor 113 deletes the nodes and lines other than "A, B ", "D, E", "F, G" and "G, H" in the graph G0. The graph obtained as a result of Step 302 is the graph G1 shown in FIG.19. Here, the deleted nodes and lines are indicated by dashed lines.

Further, in Step 303 of FIG.15, the usable model extractor 113 extracts an independent set from the graph G1 generated in Step 302. Here, an independent set is a set of nodes not mutually connected by edges. In the graph G1 of FIG.19, an independent set corresponds to (A,B), (D, E), and (F, G, H). In addition, (F, G, H) stands for a set of nodes F, G, and H here.

Furthermore, in Step 304 of FIG.15, the usable model extractor 113 extracts a base set. Here, a base set is an independent set of a maximum sum of areas of nodes attributed to respective independent sets extracted in Step 303. As is evident from FIG.16 and FIG.17, since the independent set (A, B) having the maximum area is a base set. In this connection, it should be noted that the processing is, in fact, executed for the CAD data of FIG.16.

In addition, an independent set of a predetermined sum of areas of nodes belonging to respective independent sets may be a base set.

The usable model extractor 113 searches the graph G0 for nodes in which an angle formed by nodes of a base set and face normal lines is almost 180 degrees and a distance between faces is threshold or shorter. And, in Step 305 of FIG.15, the usable model extractor 113 adds the independent set composed of the nodes obtained by searching to the base set.

"nodes in which an angle formed by nodes of a base set and face normal line is almost 180 degrees (namely, the same vector and the opposite direction) and distances between faces are threshold or shorter" are the nodes facing to a base set, and distances between configuration faces corresponding to nodes are a predetermined value (thickness or the like) or shorter.

In FIG.17, "nodes in which face normal line is almost 180 degrees and a distances between face is threshold or shorter" corresponding to the node A in a base set are the nodes E and I. Likewise, "nodes in which face normal line is almost 180 degrees and a distance between faces is threshold or shorter" corresponding to the node B in the base set is the node D.

Thus, the usable model extractor 113 adds (D, E, I) to the base set in Step 305 in FIG.15.

Subsequently, in Step 306 in FIG.15, the usable model extractor 113 deletes the nodes of base sets (A, B, C, D, E, I) from the graph in Step 706 to generate the graph G2 (a third graph). FIG.20 shows the graph G2 generated in Step 306.

Thereafter, in Step 307 in FIG.15, the usable model extractor 113 extracts the independent sets (F, G, H) from the graph G2. Here, the face of extracted independent set is a usable CAD.

Next, in Step 308 in FIG.15, the usable model extractor 113 searches for elements of a mesh data inside the extracted usable CAD, and designates such a set of elements as a usable mesh which is registered in the usable model database 123 as an associated data with a usable CAD.

Thereby, usable mesh and usable CAD are extracted without an operation by a human also in a solid mesh.

The processing indicated in FIG.5 to FIG.20 enables a usable CAD and a usable mesh corresponding to the CAD member 602 to be extracted from a CAD data shown in FIG.16 without an operation by a human.

### (Search processing)

Step 111 in FIG.3B will now be described.

As mentioned above, the search processor 114 searches a CAD data to be divided into meshes (a mesh generation target CAD data) for the parts (similar parts) similar to a usable CAD. For instance, the extraction processor 114 calculates a similarity mainly on the basis of the difference between the feature amount of partial shapes of the mesh generation target CAD data designated through the input and output unit 131 and the feature amount of shapes of a usable CAD.

Such a search processing can be performed by the known techniques, for example, disclosed in Japanese Unexamined Patent Application Publication No.2007-280129 and in "Hongshen Wang, Lin Zhang and Yonggui Zhang, "Partial Matching of 3D CAD Models with Attribute Graph", Applied Mechanics and Materials, Vol.528(2014), pp.302-309".

### (Mesh generation processing)

The mesh generation processing of Step 112 in FIG.3B will now be described.

The mesh generating processor generates a mesh for parts (a non-similar part) in which no similar usable CAD haven't been found as a result of Step 111 of FIG.3B in a mesh generation target CAD data to be divided into meshes. The generated mesh data is referred to as a mesh member for a non-similar part (a non-similar partial mesh data). Here, the mesh generating processor 115 deletes configuration faces of similar parts from the mesh generation target CAD data. Then, the mesh generating processor 115 generates a mesh for a shape composed of remaining configuration faces. As the methods for generating mesh, the techniques disclosed in Japanese Patent Application Publications No.8-138082 and No.11-110586 can be applied.

In addition, the shape composed of configuration faces which is what is left in a mesh generation target CAD data (a CAD data to be divided into meshes) after deleting configuration faces of similar parts has holes in the deleted similar parts. Thus, there are some cases where a normal mesh cannot be generated as it is. In this case, for example, it is possible to execute a fill-up processing using the technique disclosed, for example, in "Tanimoto, Nakamura, Takei, "Creation of a filling-hole surface by using CAE simulation", Proceedings of the Japan Society for Precision Engineering, 2010(0), pp.133-134".

### (Mesh connection processing)

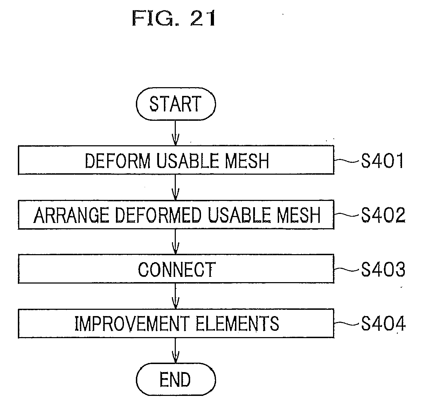

Next, the mesh connection processing in Step 113 in FIG.3B will now be described with reference to FIG.21 to FIG.23.

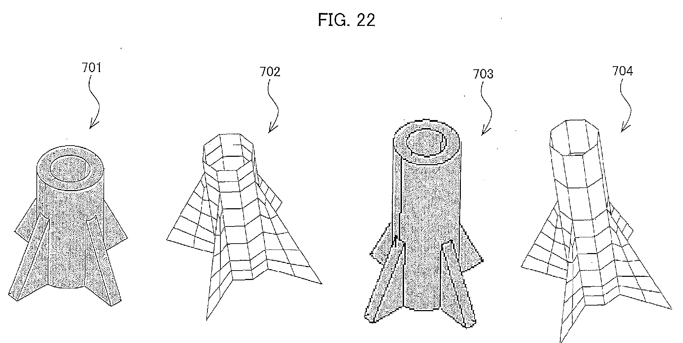

FIG.21 is a flowchart indicating the detailed procedure of the mesh generation processing according to the first embodiment. FIG.22 is a figure showing a mesh deformation method. FIG.24A and FIG.24B are figures showing a mesh connection method.

First, in Step 401 in FIG.21, the mesh connecting processor 116 deforms a usable mesh so as to fit to a shape of a corresponding similar part. This processing can be performed by the techniques disclosed, for example, in Japanese Unexamined Patent Application Publication No.2006-301753.

As an example, where a usable CAD 701 in FIG.22 has a CAD member 703 as a similar part, the mesh connecting processor 116 deforms a usable mesh 702 so as to fit to the CAD member 703 in Step 403. Consequently, the mesh member indicated by a symbol 704 is obtained.

In Step 402 in FIG.21, the mesh connecting processor 116 arranges a usable mesh deformed in Step 401 on mesh members of a non-similar part. Positioning is determined mainly on the basis of coordinates of a mesh generation target CAD data.

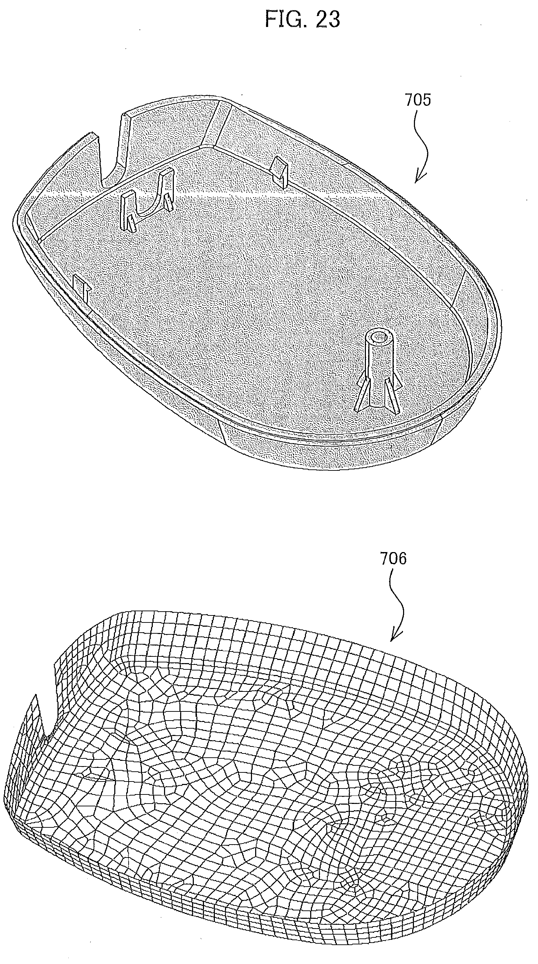

A symbol 707 in FIG.24A shows the mesh data in which the usable mesh deformed in Step 402 is arranged on a mesh member 706 of a non-similar part in the mesh generation target CAD data 705 indicated in FIG.23.

Successively, in Step 402 in FIG.21, the mesh connecting processor 116 connects an arranged usable mesh and a mesh member of a non-similar part.

There are two connecting methods described below.
(A1) The mesh connecting processor 116 extracts intersecting elements from a usable mesh and a mesh member of a non-similar part and divides elements in the intersection parts. The mesh connecting processor 116 repeats such a processing for all intersecting elements. Here, intersecting elements mean a state that nodes are not shared by elements together and nodes of one element "A" exists in a face of the other element "B". And, "dividing elements in intersection parts" means providing element edges from the nodes of the element "A" to the nodes of the element "B". As a result, the element "B" is divided into a plurality of elements.
(A2) The mesh connecting processor 116 transfers nodes in a mesh member of a non-similar part such that they have the same coordinates as nodes of a usable mesh.

As these methods (A1) and (A2) are known techniques, the detailed description will be omitted here.

The mesh connecting processor 116 connects a usable mesh and a mesh member of a non-similar part by the methods (A1) and (A2) and, if necessary, combining other methods with them.

The processing of Step 404 is executed for a mesh data 707 in FIG.24A, so that a mesh data 708 in FIG.24B is obtained.

Thereafter, in Step 404 in FIG.21, the mesh connecting processor 116 improves the elements deteriorated in qualities. "To improve the elements deteriorated in qualities" mainly means eliminating elements reduced extremely as a result of the processing of Step 403.
The processing of Step 404 can be performed, for example, by the technique disclosed in Japanese Unexamined Patent Application Publication No.2008-107960.

Thus, a mesh satisfying a specification can be generated by using parts of a mesh data which has already been used for a simulation without inputting parameters such as a mesh size and a quality. Accordingly, using parts of a mesh data which has been used for a simulation and by which it is confirmed that sufficient accuracy is obtained makes it possible to generate a new mesh succeeding the shape and quality of this mesh. Consequently, generating a mesh for similar parts of a mesh generation target CAD data becomes possible without an operation by a human, resulting in improvement of an efficiency of mesh data generation.

### (Embodiment 2)

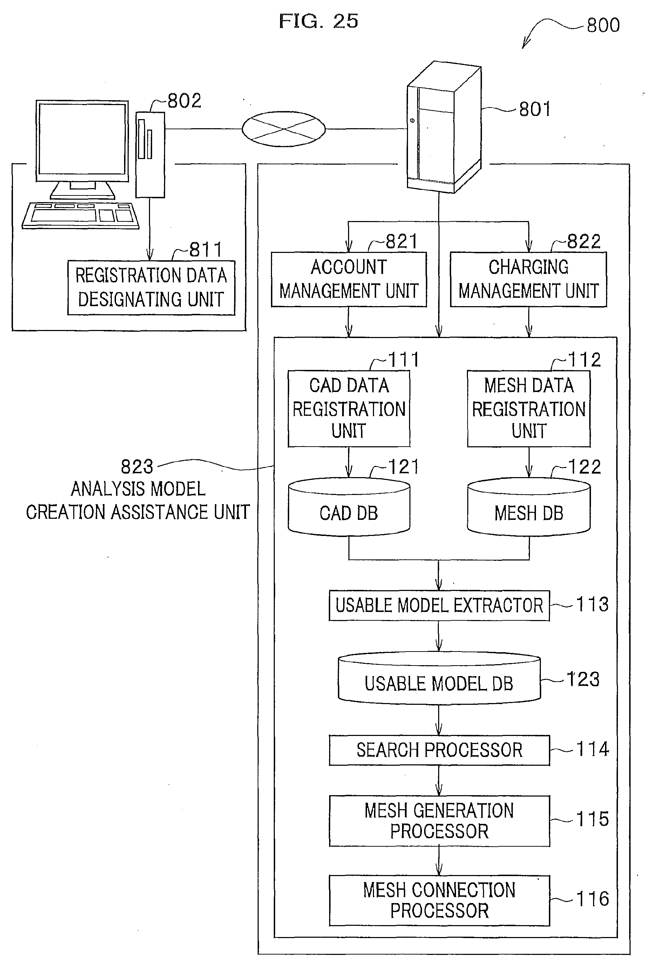

FIG.25 is a figure indicating a configuration example of the analysis model creation assistance system according to a second embodiment.

The analysis model creation assistance system includes a server 801 and a terminal device 802 mutually connected by a network.

The terminal device 802 includes a registration data designating unit 811 for designating data files of a CAD data and a mesh data to be registered in the server 801 through an input unit not illustrated in the terminal device 802, and transmitting the data files to the server 801 through a network.

Also, the server 801 includes an account management unit 821 and a charging management unit 822, and an analysis model creation assistance unit 823. In addition, the account management unit 821 and the charging management unit 822 may be provided respectively in different devices from the server 801.

The account management unit 821 manages an access authority and an execution authority of a user in the server 801. In other words, the account management unit 821 limits a user capable of using usable models on the basis of information input through the terminal device 802. Such limitation can enhance securities of usable models.

Furthermore, the charging management unit 822 manages the transfers of advertisement and usage fees in exchange for usage of the analysis model creation assistance system 800 and a registration of usable models.

Since the analysis model creation assistance unit 823 has the same configuration as the analysis model creation assistance device 1 in FIG.1, the description will be omitted here. Such managements enable the present invention to be applied into business.

In addition, the account management unit 821, the charging management unit 822, and the analysis model creation assistance unit 823 are embodied respectively, when programs stored in the storage 103 are developed in the storage 101 and executed by the CPU 102.

A system as shown in a FIG.25 can provide the following business method.

As an example, a manufacturer A creates a CAD data. And, an outsourcer B creates a mesh data corresponding to the CAD data created by the manufacture A. The manufacture A and the outsourcer B registers the CAD data and the mesh data in the CAD database 121 and the mesh database 122 in the server 801 through the registration data designating unit 811 in the terminal device 802 possessed by the manufacture A and the outsourcer B respectively.

In this case, the manufacture A may designate users and companies allowed to access to the mesh data registered by the outsourcer B

Further, the analysis model creation assistance unit 823 in the server 801 generates a usable mesh and a usable CAD on the basis of a registered CAD data and a mesh data.

Here, the outsourcer B can receive a consideration for usage of registering a usable model as well as a consideration for mesh creation.

On the other hand, as more data are registered as usable models by the manufacture A, the ratio of mesh generated automatically without outsourcing increases.

Furthermore, a supplier C supplying the manufacture A with members not only supplies members but also registers a CAD data and a mesh data of supplied members in the CAD database 121 and the mesh database 122 in the server 801 through the registration data designating unit 811.Consequently, it is not necessary for the manufacture A to create a mesh of such a member, while the supplier C receives a consideration for registration of the CAD data and the mesh data of the supplied members.

Thus, when the analysis model creation assistance system is utilized by a plurality of companies through a network, a mesh data can be shared among companies. Since a CAD data and a mesh data are not only shared as they are but also registered as extracted usable models, sharing while the know-how is concealed is achieved. This can be applied to business, too.

The present embodiment is assumed to employ a mesh data used mainly for a finite element method, however replacing a mesh by elements such as a pixel and a polygon will enable the present embodiment to be applied into a two-dimensional image and a three-dimensional image.

The present invention is not limited to the above embodiments but includes various versions. For example, the above embodiments are detailed descriptions to give clear descriptions of the present invention, which is not necessarily limited to all of the configurations described. Further, a part of configuration in one embodiment can be replaced with a configuration of the other embodiment, and also a configuration of one embodiment can be added to a configuration of the other embodiment. Furthermore, in parts of configurations of respective embodiments, addition of, deletion of, and replacement with the other configurations can be performed.

The above respective configurations, functions, the respective parts 111 to 116, 811, 821, 822, and the respective databases 121 to 123 or the like may be achieved in a hardware, for example, in such a way that some or all of them are designed with integrated circuits. Additionally, as shown in FIG.2, the above respective configurations and functions or the like may be achieved in software in such a way that processors such as the CPU 102 interpret and run programs realizing the respective functions. Information such as programs, tables, and files to the respective functions can be stored in recording mediums such as a memory and a SSD (Solid State Drive), IC (Integrated Circuit), SD (Secure Digital) card, and DVD (Digital Versatile Disc) besides HD.

Further, in the respective embodiments, control lines and information lines necessary for descriptions are shown, thus all control lines and information lines are not necessarily shown on a product. It may be assumed that almost all of the configurations are connected with each other practically.

### [Descriptions of symbols]

- 1: analysis model creation assistance device
- 111: CAD data registration unit (acquirer)
- 112: mesh data registration unit (acquirer)
- 113: usable model extractor
- 114: search processor
- 115: mesh generating processor
- 116: mesh connecting processor
- 121: CAD database
- 122: mesh database
- 123: usable model database
- 800: analysis model creation assistance system
- 801: server
- 802: terminal device
- 811: registration data designating unit
- 821: account management unit (Authority management unit)
- 822: charging management unit
- 823: analysis model creation assistance unit

## Claims

1. An analysis model creation assistance system comprising:
an acquirer configured to acquire a mesh data divided into meshes for a simulation; and
a usable model extractor (113) configured to divide the mesh data
into a plurality of data on mesh members, and designate the mesh data corresponding to the data on the mesh members excluding a mesh member of a predetermined size as usable meshes.

2. The analysis model creation assistance system according to Claim
1, wherein
the mesh data is composed of shell meshes, and
the usable model extractor (113)
detects an element edge to which there or more elements are connected, the element edge being a boundary line of the elements constituting the mesh, and
generates a first mesh members by separating elements in the
detected element edge,
extracts the first mesh members excluding the first mesh member of the predetermines size out of the first mesh members, and
generates a second mesh member by connecting the first mesh members mutually contacted out of the first mesh members excluding the first mesh member of the predetermined size to designate the second mesh member as the usable meshes.

3. The analysis model creation assistance system according to Claim 2, wherein the usable model extractor (113)
arranges the usable mesh in the part corresponding to the usable mesh in a CAD data corresponding to the mesh data,
extracts configuration faces intersecting with normal lines of the usable meshes in the CAD data as mesh belonging faces, and
generates a usable CAD which is a CAD data corresponding to the usable meshes by connecting the mesh belonging faces and the configuration faces relating to the mesh belonging faces.

4. The analysis model creation assistance system according to Claim 3, further comprising:
a search processor (114) configured to search for similar parts, the similar parts being similar to the usable CAD in a CAD data newly input;
a mesh generating processor (115) configured to generate a non-similar part mesh data by generating mesh of CAD data excluding the similar parts in the CAD data newly input; and
a mesh connecting processor (116) configured to connect the usable mesh corresponding to the similar parts to the a non-similar part mesh data generated in the mesh generating processor (115).

5. The analysis model creation assistance system according to Claim 1, wherein
the acquire
acquires a CAD data corresponding to the mesh data besides the mesh data, and
the usable model extractor (113)
generates a first graph showing connecting relation of respective configuration faces by representing configuration faces in the CAD data as nodes,
generates a second graph which is what is left after deleting from the first graph a connecting relation, the connecting relation having angles of the predetermined value or less that is formed by tangents of respective configuration faces connecting in connection points of respective configuration faces,
designates an independent set of the predetermined sum of configuration faces of CAD data corresponding to nodes constituting the independent set in the second graph as a base set, when designating a connecting node set out of nodes in the second graph as an independent set,
generates a third graph by deleting the base set from the second graph,
designates the part composed of configuration faces of CAD data corresponding to nodes constituting an independent set in the third graph as a usable CAD, and
designates the part corresponding to the usable CAD in the mesh data as a usable mesh.

6. The analysis model creation assistance system according to Claim 5, further comprising:
a search processor (112) configured to search for similar parts, the similar parts being similar to the usable CAD in a CAD data newly input;
a mesh generating processor (115) configured to generate a non-similar part mesh data by generating mesh of CAD data excluding the similar parts in the CAD data newly input; and
a mesh connecting processor (116) configured to connect the usable mesh corresponding to the similar parts to the a non-similar part mesh data generated in the mesh generating processor (115).

7. The analysis model creation assistance system according to Claim 1, further comprising:
an authority management unit configured to determine a charging condition according to a registration status on the mesh data.

8. The analysis model creation assistance system according to Claim 1, further comprising:
An authority management unit configured to use the usable meshes on the basis of information input through an input unit.

9. An analysis model creation assistance device (1) comprising:
an acquirer configured to acquire a mesh data divided into meshes for a simulation; and
a usable model extractor configured to divide the mesh data into a plurality of data on mesh members, and designate the mesh data corresponding to the data on the mesh members excluding a mesh member of a predetermined size as usable meshes.

10. The analysis model creation assistance device (1) according to Claim 9, wherein
the mesh data is composed of shell meshes, and
the usable model extractor (113)
detects an element edge to which there or more elements are connected, the element edge being a boundary line of the elements constituting the mesh, and
generates a first mesh members by separating elements in
the
detected element edge,
extracts the first mesh members excluding the first mesh member of the predetermines size out of the first mesh members, and
generates a second mesh member by connecting the first mesh members mutually contacted out of the first mesh members excluding the first mesh member of the predetermined size to designate the second mesh member as the usable meshes.

11. The analysis model creation assistance device (1) according to Claim 10, wherein the usable model extractor (113)
arranges the usable mesh in the part corresponding to the usable mesh in a CAD data corresponding to the mesh data,
extracts configuration faces intersecting with normal lines of the usable meshes in the CAD data as mesh belonging faces, and
generates a usable CAD which is a CAD data corresponding to the usable meshes by connecting the mesh belonging faces and the configuration faces relating to the mesh belonging faces.

12. The analysis model creation assistance device (1) according to Claim 11, further comprising:
a search processor (114) configured to search for similar parts, the similar parts being similar to the usable CAD in a CAD data newly input;
a mesh generating processor (115) configured to generate a non-similar part mesh data by generating mesh of CAD data excluding the similar parts in the CAD data newly input; and
a mesh connecting processor (116) configured to connect the usable mesh corresponding to the similar parts to the a non-similar part mesh data generated in the mesh generating processor (115).

13. The analysis model creation assistance device (1) according to Claim 9, wherein
the acquire
acquires a CAD data corresponding to the mesh data besides
the mesh data, and
the usable model extractor (113)
generates a first graph showing connecting relation of respective configuration faces by representing configuration faces in the CAD data as nodes,
generates a second graph which is what is left after deleting from the first graph a connecting relation, the connecting relation having angles of the predetermined value or less that is formed by tangents of respective configuration faces connecting in connection points of respective configuration faces,
designates an independent set of the predetermined sum of configuration faces of CAD data corresponding to nodes constituting the independent set in the second graph as a base set, when designating a connecting node set out of nodes in the second graph as an independent set,
generates a third graph by deleting the base set from the second graph,
designates the part composed of configuration faces of CAD data corresponding to nodes constituting an independent set in the third graph as a usable CAD, and
designates the part corresponding to the usable CAD in the mesh data as a usable mesh.

14. The analysis model creation assistance device (1) according to Claim 13, further comprising:
a search processor (114) configured to search for similar parts, the similar parts being similar to the usable CAD in a CAD data newly input;
a mesh generating processor (115) configured to generate a non-similar part mesh data by generating mesh of CAD data excluding the similar parts in the CAD data newly input; and
a mesh connecting processor (116) configured to connect the usable mesh corresponding to the similar parts to the a non-similar part mesh data generated in the mesh generating processor (115).

15. A analysis model creation assistance program, executing steps of:
acquiring a mesh data divided into meshes for a simulation; and
dividing the mesh data into a plurality of datum on mesh members to designate a mesh data corresponding to a data on mesh members excluding mesh members of a predetermined size as a usable mesh.

16. The analysis model creation assistance program according to Claim 15, wherein
the mesh data is composed of shell meshes, and
the usable model extractor (113)
detects an element edge to which there or more elements are connected, the element edge being a boundary line of the elements constituting the mesh, and
generates a first mesh members by separating elements in
the
detected element edge,
extracts the first mesh members excluding the first mesh member of the predetermines size out of the first mesh members, and
generates a second mesh member by connecting the first mesh members mutually contacted out of the first mesh members excluding the first mesh member of the predetermined size to designate the second mesh member as the usable meshes.

17. The analysis model creation assistance program according to Claim 16, wherein the usable model extractor
arranges the usable mesh in the part corresponding to the usable mesh in a CAD data corresponding to the mesh data,
extracts configuration faces intersecting with normal lines of the usable meshes in the CAD data as mesh belonging faces, and
generates a usable CAD which is a CAD data corresponding to the usable meshes by connecting the mesh belonging faces and the configuration faces relating to the mesh belonging faces.

18. The analysis model creation assistance program according to Claim 17, further comprising:
a search processor (114) configured to search for similar parts, the similar parts being similar to the usable CAD in a CAD data newly input;
a mesh generating processor (115) configured to generate a non-similar part mesh data by generating mesh of CAD data excluding the similar parts in the CAD data newly input; and
a mesh connecting processor (116) configured to connect the usable mesh corresponding to the similar parts to the a non-similar part mesh data generated in the mesh generating processor (115).

19. The analysis model creation assistance program according to Claim 15, wherein
the acquire
acquires a CAD data corresponding to the mesh data besides the mesh data, and
the usable model extractor (113)
generates a first graph showing connecting relation of respective configuration faces by representing configuration faces in the CAD data as nodes,
generates a second graph which is what is left after deleting from. the first graph a connecting relation, the connecting relation having angles of the predetermined value or less that is formed by tangents of respective configuration faces connecting in connection points of respective configuration faces,
designates an independent set of the predetermined sum of configuration faces of CAD data corresponding to nodes constituting the independent set in the second graph as a base set, when designating a connecting node set out of nodes in the second graph as an independent set,
generates a third graph by deleting the base set from the second graph,
designates the part composed of configuration faces of CAD data corresponding to nodes constituting an independent set in the third graph as a usable CAD, and
designates the part corresponding to the usable CAD in the mesh data as a usable mesh.

20. The analysis model creation assistance program according to Claim 19, further comprising:
a search processor (114) configured to search for similar parts, the similar parts being similar to the usable CAD in a CAD data newly input;
a mesh generating processor (115) configured to generate a non-similar part mesh data by generating mesh of CAD data excluding the similar parts in the CAD data newly input; and
a mesh connecting processor (116) configured to connect the usable mesh corresponding to the similar parts to the a non-similar part mesh data generated in the mesh generating processor (116).
